# EUROPEAN PATENT APPLICATION

(11) **EP 4 589 844 A1**
(43) Date of publication of application: **23.07.2025**
(21) Application number: 23865213.5
(22) Date of filing: 24.08.2023
(51) Int. Cl.: H02S 40/34

(54) **PHOTOVOLTAIC MODULE**

(30) Priority: 12.09.2022 JP 2022144528
(71) Applicant: Sharp Kabushiki Kaisha, Sakai City, Osaka 590-8522 (JP)
(72) Inventor: OKAMOTO, Chikao, Sakai City, Osaka 590-8522 (JP); TAKABA, Yoshiroh, Sakai City, Osaka 590-8522 (JP)
(74) Representative: Müller Hoffmann & Partner
(86) International application number: PCT/JP2023/030402
(87) International publication number: WO 2024/057855

(57) **Abstract**

A photovoltaic module includes a plurality of photovoltaic cell connection units in each of which a plurality of photovoltaic cells adjacent to each other in a first direction is connected in series with each other. Two of the photovoltaic cell connection units, the two being adjacent in a second direction orthogonal to the first direction, are connected in series with each other by bus bars to constitute a photovoltaic string. An end of an output wiring member is connected to a starting end or a terminating end of the photovoltaic cell connection unit, and another end of the output wiring member establishes electrical continuity with a terminal box. The terminal box includes bypass diodes, and each of the plurality of photovoltaic cell connection units is connected in parallel with corresponding one of the bypass diodes.

## Description

### Technical Field

The present disclosure relates to a photovoltaic module.

### Background Art

A photovoltaic module includes photovoltaic strings in which a plurality of photovoltaic cells as power generating elements is electrically connected in series. Bypass diodes for diverting one or more photovoltaic strings are often provided on the current path. The bypass diodes are electrically connected in parallel with the respective photovoltaic strings. When a trouble occurs in a part of the photovoltaic strings, an electric current is allowed to flow without passing the troubled photovoltaic string(s).

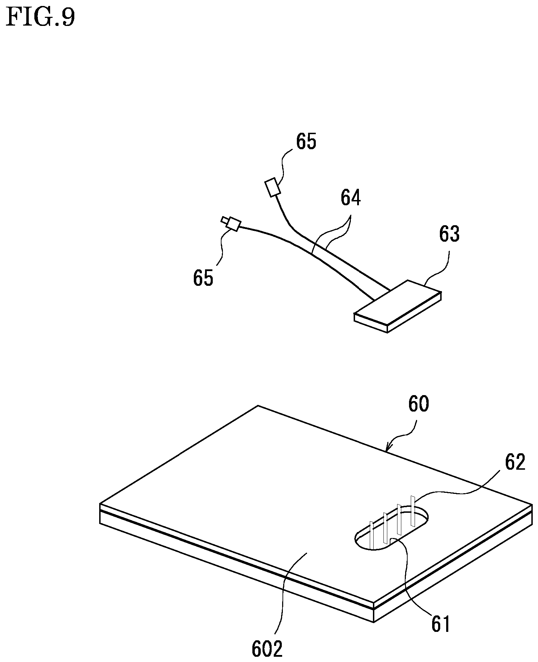

Typically, bypass diodes are provided inside a terminal box for extracting output from the photovoltaic module. In a conventional structure exemplified in FIG. 9, output wiring members 62 are drawn out from a slit 61 formed in a back surface 602 side of a photovoltaic module 60, and a terminal box 63 for extracting output from the photovoltaic module 60 is attached to cover the output wiring members 62. External connection cables 64, each having a connector 65 at an extreme end thereof, extend from the terminal box 63.

For example, a photovoltaic module disclosed in PTL 1 has a following structure. From a photovoltaic cell at an end of a line of string, first wiring members extend in a lengthwise direction and are connected with second wiring members. The second wiring members connect adjacent strings in a transverse direction to form a group of strings. A terminal box connected to the group of strings is provided on a back side of a back surface protection member. Among the four second wiring members, two connect adjacent strings with each other, and each of the other two connects a line of the strings with the terminal box.

### Prior Art Documents

### Patent Documents

PTL 1: Japanese Patent No. 6635389

### Summary of Invention

### Technical Problem

In the photovoltaic module disclosed in PTL 1, six lines of the strings are connected in series to form a group of strings. The second wiring members contained in the group of strings are connected to the terminal unit equipped with bypass diodes. When the photovoltaic cells constituting the group of strings are partially shaded due to changes in seasons or insolation hours, power generation is hindered in at least two lines of the strings that are connected in series with the shaded photovoltaic cells.

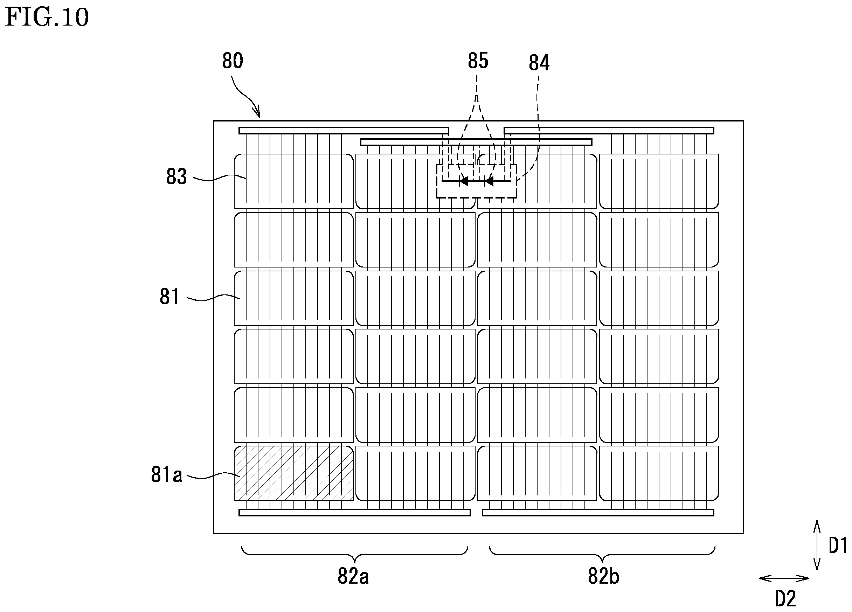

For example, FIG. 10 shows an example of a photovoltaic module 80 that includes photovoltaic strings 82a, 82b in each of which six photovoltaic cells 81 are connected in series in a line by wiring members 83 and two such lines are connected in series. As for a circuit configuration, each of the two photovoltaic strings 82a, 82b is connected in parallel with a bypass diode 85 disposed inside a terminal box 84. In this photovoltaic module 80, suppose that the sunlight is obstructed by a certain structure or the like, and that a photovoltaic cell 81a, for example, is shaded. The partial shading in the photovoltaic module activates the bypass diode 85 connected to the photovoltaic string 82a, and causes a loss of the amount of generated power in two lines of the photovoltaic cells 81. Eventually, the amount of generated power in the photovoltaic module 80 is reduced to the amount obtainable only from the other photovoltaic string 82b, which significantly deteriorates power generation efficiency. The above-described issue has been recognized as a problem in the photovoltaic module of the conventional structure.

The present disclosure is made in view of the above-mentioned problem, and intends to provide a photovoltaic module that can reduce the influence of shading over a part of the photovoltaic cells constituting the photovoltaic module and that can thereby mitigate deterioration in power generation efficiency.

### Solution to Problem

According to the present disclosure, a solution for achieving the above-mentioned object provides a photovoltaic module that includes a photovoltaic string and a terminal box, the photovoltaic string including a plurality of photovoltaic cells connected in series with each other. The photovoltaic string includes a plurality of photovoltaic cell connection units in each of which the plurality of photovoltaic cells adjacent to each other in a first direction is connected in series with each other, and also includes a turn-back portion at which two of the plurality of photovoltaic cell connection units are connected in series with each other, the two photovoltaic cell connection units being adjacent to each other in a second direction orthogonal to the first direction. The terminal box includes a plurality of bypass diodes. The turn-back portion is provided with an output wiring member, and each of the plurality of photovoltaic cell connection units is connected in parallel with corresponding one of the bypass diodes.

Preferably, in the photovoltaic module according to the above configuration, the turn-back portion includes a bus bar connected to a starting end or a terminating end of each of the photovoltaic cell connection units, and the output wiring member is connected to the bus bar.

Preferably, in the photovoltaic module according to the above configuration, the terminal box includes a plurality of terminals connected with the plurality of bypass diodes, and the output wiring member has an end thereof connected to the bus bar and has another end thereof connected, directly or via a connection cable, to corresponding one of the terminals.

In the photovoltaic module according to the above configuration, the photovoltaic string may include the plurality of photovoltaic cell connection units in the first direction.

In the photovoltaic module according to the above configuration, the photovoltaic string may be sealed between a transparent substrate and a back surface protection member. The output wiring member may be arranged between the photovoltaic cell connection units and the back surface protection member and may be led out to the terminal box.

In the photovoltaic module according to the above configuration, the photovoltaic string may be sealed between a transparent substrate and a back surface protection member. The output wiring member may penetrate the back surface protection member, may be drawn out to an outside of the back surface protection member, and may be connected to the terminal box via a connection cable.

### Advantageous Effect of Invention

The present disclosure can reduce the influence of shading over a part of the photovoltaic cells constituting the photovoltaic module, and can enhance power generation efficiency.

### Brief Description of Drawings

[FIG. 1] FIG. 1 is a schematic plan view of a photovoltaic module according to Embodiment 1 of the present disclosure.
[FIG. 2] FIG. 2 is a circuit diagram of the photovoltaic module.
[FIG. 3] FIG. 3 is a perspective view showing a modified example of the photovoltaic module.
[FIG. 4] FIG. 4 is a schematic plan view of a photovoltaic module according to Embodiment 2 of the present disclosure.
[FIG. 5] FIG. 5 is a schematic plan view of a photovoltaic module according to Embodiment 3 of the present disclosure.
[FIG. 6] FIG. 6 is a schematic bottom view of the photovoltaic module.
[FIG. 7] FIG. 7 is an enlarged view showing a part of a back surface side of the photovoltaic module.
[FIG. 8] FIG. 8 is a schematic bottom view showing a main part in another example of the photovoltaic module according to Embodiment 3 of the present disclosure.
[FIG. 9] FIG. 9 is a perspective view of a conventional photovoltaic module.
[FIG. 10] FIG. 10 is a plan view showing another example of the conventional photovoltaic module.

### Description of Embodiments

Photovoltaic modules according to embodiments of the present disclosure are described with reference to the drawings.

### (Embodiment 1)

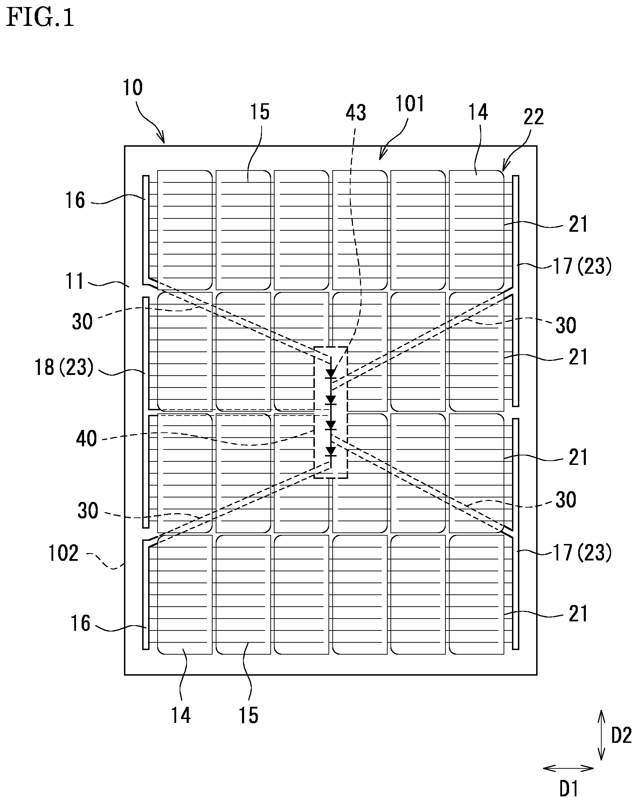

FIG. 1 is a schematic plan view of a photovoltaic module 10 according to Embodiment 1 of the present disclosure, showing a light-receiving surface 101 side of the photovoltaic module 10. In the following description of the photovoltaic module 10, the light-receiving surface 101 means a surface on which the sunlight is mainly incident, and a back surface means a surface opposite to the light-receiving surface. Note that FIG. 1 omits a resin sealing layer in the photovoltaic module 10, and provides a see-through illustration of a plurality of photovoltaic cells 14 through a transparent substrate 11 that is made of clear glass or the like and laminated on the photovoltaic cells 14.

The photovoltaic module 10 is composed of the transparent substrate 11 on the light-receiving surface 101 side, a back surface protection member (to be described below) on a back surface 102 side, and a photovoltaic string 22 and some other components sealed therebetween. The photovoltaic string 22 contains the plurality of photovoltaic cells 14 connected in series with each other. Light is incident on the photovoltaic cells 14 through the transparent substrate 11. The photovoltaic cells 14 are flat plate-like photovoltaic elements that generate electric power in response to light irradiation. The photovoltaic cells 14 adjacent in a first direction D1 are connected in series with each other by conductive wiring members 15.

The plurality of photovoltaic cells 14 is arranged in a matrix along the first direction D1 and a second direction D2 orthogonal to the first direction D1. Each of the photovoltaic cells 14 has a flat plate-like shape. The configuration shown in FIG. 1 uses, for example, split cells for which photovoltaic cell substrates having a size of about 156 mm² are split into two pieces.

Split cells, as used herein, mean small-size cells prepared from a standard-size cell (a cell for one solar wafer, also called full cell) split into certain pieces. As an example of the split cells, a standard-size cell may be split into half (half cells). Split cells can reduce the value of current per cell (a half cell can reduce the current value by half), and can reduce power loss in the photovoltaic module 10 accordingly.

Besides, split cells can increase the number of serial connections in comparison with standard-size cells, and can thereby raise the voltage. In the illustrated configuration, the photovoltaic cells 14 are half cells. Although the photovoltaic cells 14 in the illustrated configuration are half cells prepared from standard-size cells split into half, standard-size cells may be split into three or four to provide split cells. Additionally, a half cell may be split further into half to provide split cells having a substantially square shape.

The photovoltaic string 22 provided in the photovoltaic module 10 includes a plurality of photovoltaic cell connection units 21. In each photovoltaic cell connection unit 21, a plurality of photovoltaic cells 14 adjacent in the first direction D1 in the drawing is connected in series with each other. In the configuration shown in FIG. 1, six photovoltaic cells 14 are aligned in the first direction D1 and electrically connected in series by the wiring members 15 to form one photovoltaic cell connection unit 21.

In the second direction D2 orthogonal to the first direction D1, adjacent photovoltaic cell connection units 21 are connected in series, two by two, at turn-back portions 23 by bus bars 17, 18. The turn-back portions 23 are provided along both ends in the first direction D1 of the photovoltaic module 10.

In the turn-back portion 23 for the series-connected photovoltaic cells 14 at a first end in the first direction D1 of the photovoltaic module 10, the bus bar 18 is connected to the wiring members 15 so as to connect adjacent photovoltaic cell connection units 21 in series with each other. In the turn-back portions 23 for the series-connected photovoltaic cells 14 at a second end in the first direction D1 of the photovoltaic module 10, the bus bars 17 are connected to the wiring members 15 so as to connect adjacent photovoltaic cell connection units 21 in series with each other. Bus bars 16 are connected to the photovoltaic cell connection units 21 at both ends in the second direction D2. The bus bar 16 at one end is connected to the photovoltaic cell connection unit 21 on a high-potential side in the second direction D2, and the bus bar 16 at the other end is connected to the photovoltaic cell connection unit 21 on a low-potential side in the second direction D2.

At the turn-back portions 23, starting ends or terminating ends (in this case, both ends in the first direction D1) of the photovoltaic cell connection units 21 are connected to the bus bars 17, 18. All of the bus bars 16, 17, 18 are also connected with output wiring members 30 for extracting output from the photovoltaic cell connection units 21. Each output wiring member 30 is a band-like conductive member, made of an elongated a band-like (or ribbon-like) substrate whose outer surface is coated with a conductive adhesive or coated by soldering. The material for the substrate is not particularly limited and, for example, may be a metal such as copper.

The output wiring members 30 are enclosed inside the photovoltaic module 10 as far as the position of a terminal box 40. When the output wiring members 30 are sealed between the back surface of the photovoltaic cells 14 and the back surface protection member, the output wiring members 30 are routed with use of insulating films or the like so as to insulate the photovoltaic cells 14 and the output wiring members 30 from each other. The output wiring members 30 and the bus bars 16, 17, 18 may be integrated wiring members or may be prepared separately and attached together.

The output wiring members 30 have first ends thereof connected to the bus bars 16, 17, 18, and have second ends thereof led to the terminal box 40. As described above, the photovoltaic string 22 is sealed between the transparent substrate 11 and the back surface protection member, and the output wiring members 30 are arranged between the photovoltaic cell connection units 21 and the back surface protection member and led out to the terminal box 40.

The terminal box 40 is attached to a back surface 102 of the photovoltaic module 10. The terminal box 40 includes a plurality of terminals (not shown) to which the output wiring members 30 are connected, and also includes bypass diodes 43 connected to the terminals. In the illustrated configuration, the terminal box 40 is positioned at a central part of the back surface 102, and contains four bypass diodes 43. Among the plurality of terminals, those at both ends are also equipped with external output cables (not shown) for extracting output from the photovoltaic string 22.

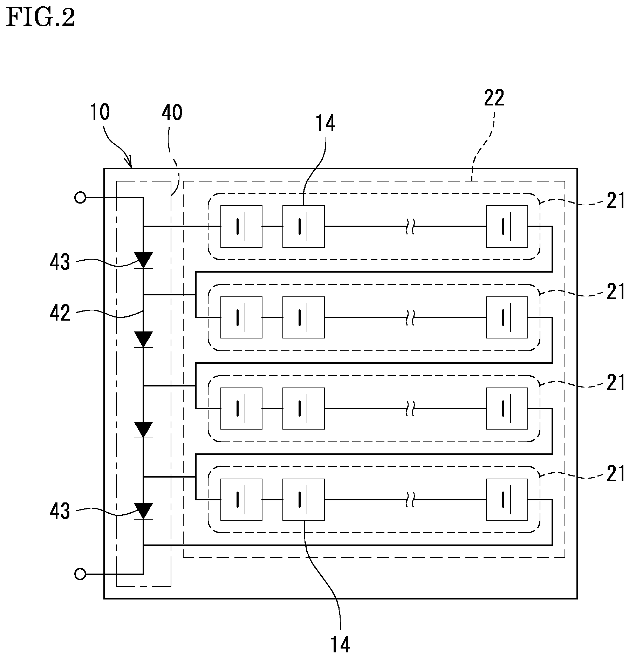

FIG. 2 is a circuit diagram of the photovoltaic module 10. In the photovoltaic module 10, each photovoltaic cell connection unit 21 constitutes one series circuit in which six photovoltaic cells 14 are connected in series. The photovoltaic module 10 includes four such photovoltaic cell connection units 21. The four photovoltaic cell connection units 21 are electrically connected with adjacent photovoltaic cell connection units 21 to form one photovoltaic string 22. In the resulting electric circuit, the photovoltaic module 10 as a whole provides one series circuit in which the photovoltaic cells 14 are connected in series in 6×4 arrangement, with 24 (twenty-four) serial connections.

Regarding the series-connected photovoltaic cells 14, note that FIG. 2 simply shows two cells at the starting end and one cell at the terminating end. In actual implementation of the photovoltaic cells 14, a predetermined number of cells are arranged from the starting end to the terminating end. For example, FIG. 1 shows six photovoltaic cells 14 arranged in the first direction D1. In this context, the starting end and the terminating end indicate both ends of the serial connections in each photovoltaic cell connection unit 21. For example, when the starting end is a positive electrode-side end, the terminating end is a negative electrode-side end.

Referring to the terminal box 40 shown in FIG. 2, an anode of each bypass diode 43 is connected to a negative electrode terminal of a corresponding photovoltaic connection unit 21, and a cathode of the bypass diode 43 is connected to a positive electrode terminal of the same photovoltaic connection unit 21. Accordingly, each bypass diode 43 is electrically connected to the starting end and the terminating end of a photovoltaic connection unit 21 in which six photovoltaic cells 14 are arranged in a line, and thus each bypass diode 43 is connected in parallel with the photovoltaic connection unit 21. The plurality of terminals 42 is connected in series with each other via the plurality of bypass diodes 43. This configuration can provide a bypass that serves when a trouble occurs in a part of the photovoltaic cells 14.

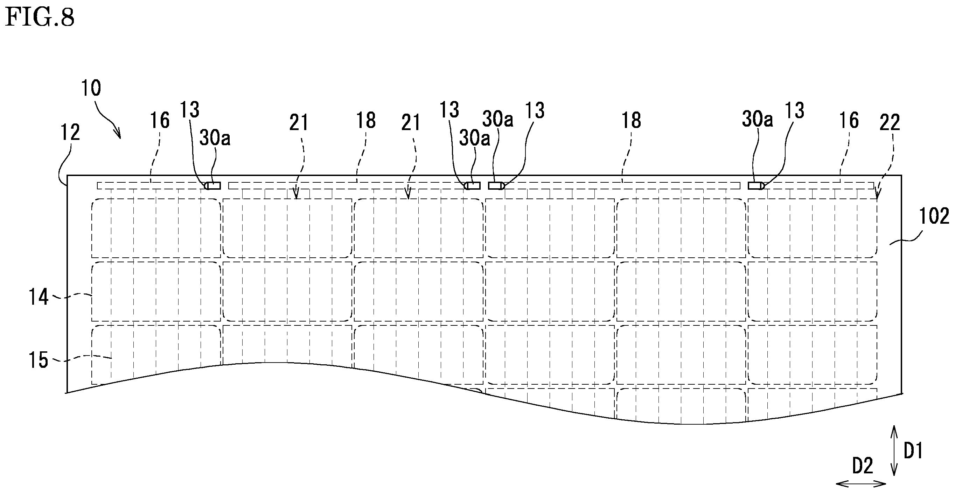

As shown by the conventional photovoltaic module 80 in FIG. 8, the terminal box 84 including the bypass diodes 85 is typically disposed at an end in the first direction D1 of the photovoltaic module 80. Partial shading due to the shaded photovoltaic cell 81a affects the photovoltaic string 82a entirely, and causes a loss of the amount of generated power in two lines of the photovoltaic cells 81. Besides, the photovoltaic cell 81a with deteriorated power generating capacity acts as a resistance element. The resistive photovoltaic cell 81a produces heat and turns into a hot spot, and may even get broken. Eventually, the amount of generated power in the photovoltaic module 80 is reduced to the amount obtainable only from the other photovoltaic string 82b, which significantly deteriorates power generation efficiency. The above-described issue has been recognized as a problem in the photovoltaic module of the conventional structure.

On the other hand, according to the configuration shown in FIG. 1, one connection unit is composed of six photovoltaic cells 14 connected in series with each other. Such units containing the six photovoltaic cells 14 are provided with the turn-back portions 23, and are connected to the terminal box 40 by the output wiring members 30 via the bus bars 17, 18.

As understood from FIG. 2, when the power generation state of the photovoltaic module 10 is normal, no electric current flows through the bypass diodes 43. However, when a part of the photovoltaic cells 14 is in the shade of a certain structure or the like, the photovoltaic module does not generate a sufficient power. Then, the one or more shaded photovoltaic cells 14 turn into resistance elements, consume electric power, generate back bias, and activate the bypass diode 43. Eventually, the photovoltaic cell connection unit 21 including the one or more shaded photovoltaic cells 14 can be bypassed.

In the photovoltaic module 10, the photovoltaic cell connection units 21 that have fewer serial connections than the photovoltaic string 22 are respectively equipped with the output wiring members 30, and the bypass diodes 43 are respectively connected in parallel with the photovoltaic cell connection units 21. In this case, deterioration in power generating capacity is confined to one line of the photovoltaic cell connection unit 21 that contains the one or more shaded photovoltaic cells 14. The other lines of the photovoltaic cell connection units 21 are not affected by shading, and hence not troubled by any decrease in the amount of generated power.

Thus, while only one bypass diode 43 is activated to bypass the photovoltaic cell connection unit 21 whose power generating capacity has deteriorated, the other three photovoltaic cell connection units 21 can generate power normally. In other words, even when a photovoltaic cell 14 is shaded, the amount of generated power is lost in the single photovoltaic cell connection unit 21 containing the shaded photovoltaic cell 14. This configuration can prevent a hot spot, and can thereby prevent the influence of shading from spreading across the entire photovoltaic string 22 including the other adjacent photovoltaic cell connection units 21. In the photovoltaic module 10 as a whole, deterioration in power generating capacity is confined to one line including the shaded photovoltaic cell 14, and a decrease in the amount of generated power by the photovoltaic module 10 is mitigated in comparison with the conventional structure.

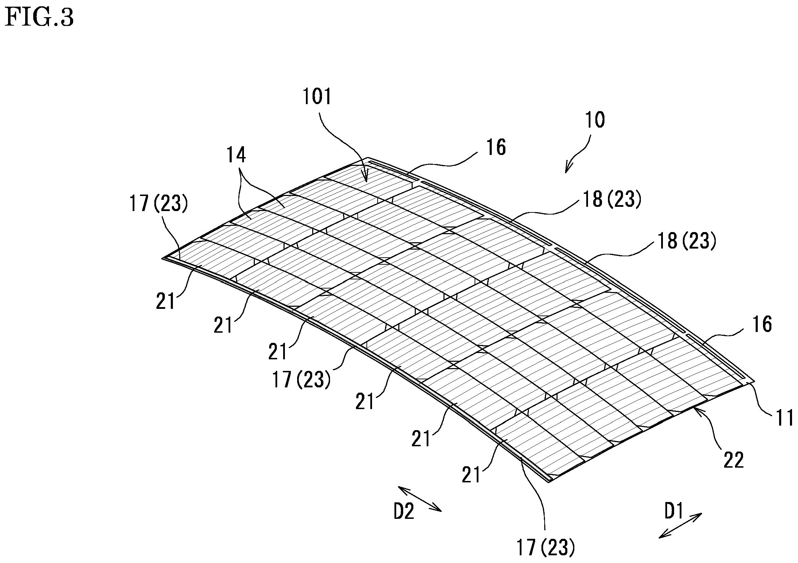

As shown in FIG. 3, the photovoltaic module 10 as a whole may have a curved shape that is bent in the first direction D1 and in the second direction D2 so as to be mounted on a curved part, for example, on a roof of a vehicle or the like. In addition, six photovoltaic cell connection units 21 may be connected in series via the bus bars 17, 18 at the turn-back portions 23, so as to provide a photovoltaic module 10 that holds a photovoltaic string 22 in which 36 (thirty-six) photovoltaic cells are connected in series in 6×6 arrangement. The plurality of photovoltaic cells 14 is arranged along the curved transparent substrate 11.

A photovoltaic module mounted on a mobile object, for example, on a vehicle or the like should be distinguished from a fixed photovoltaic module in the following respects. While the mobile object is moving, the photovoltaic module is more likely to be shaded by a certain structure, tree, or the like, and a shaded portion is changeable. Besides, an installation surface for the photovoltaic module is not a flat surface but a curved surface having various curvatures. In this situation, even when the photovoltaic module is evenly irradiated with sunlight, the amount of insolation may be uneven among the photovoltaic cells depending on their positions, and hence the value of current generated by the photovoltaic cells may not be equal among themselves.

As described above, the photovoltaic module 10 according to the present embodiment is configured to constitute each photovoltaic cell connection unit 21 by a unit containing a relatively small number of serial connections, to connect such photovoltaic cell connection units 21 in parallel with the bypass diodes 43, and thereby to reduce the number of affected photovoltaic cells 14. Accordingly, even in the above-mentioned situation, this configuration can mitigate a decrease in the amount of generated power by the photovoltaic module 10.

In the photovoltaic module 10, the number of photovoltaic cells 14 contained in each photovoltaic cell connection unit 21 is not limited to six, as exemplified, but may be less to provide a smaller unit or may be optional. In addition, the total number of photovoltaic strings 22 that constitute the photovoltaic module 10 is not limited to the illustrated configuration. The photovoltaic cells 14 are not limited to split cells but may be standard-size cells. When the number of serial connections of the photovoltaic cells 14 constituting each photovoltaic cell connection unit 21 is fewer, the influence by the shaded photovoltaic cell(s) 14 can be mitigated further.

### (Embodiment 2)

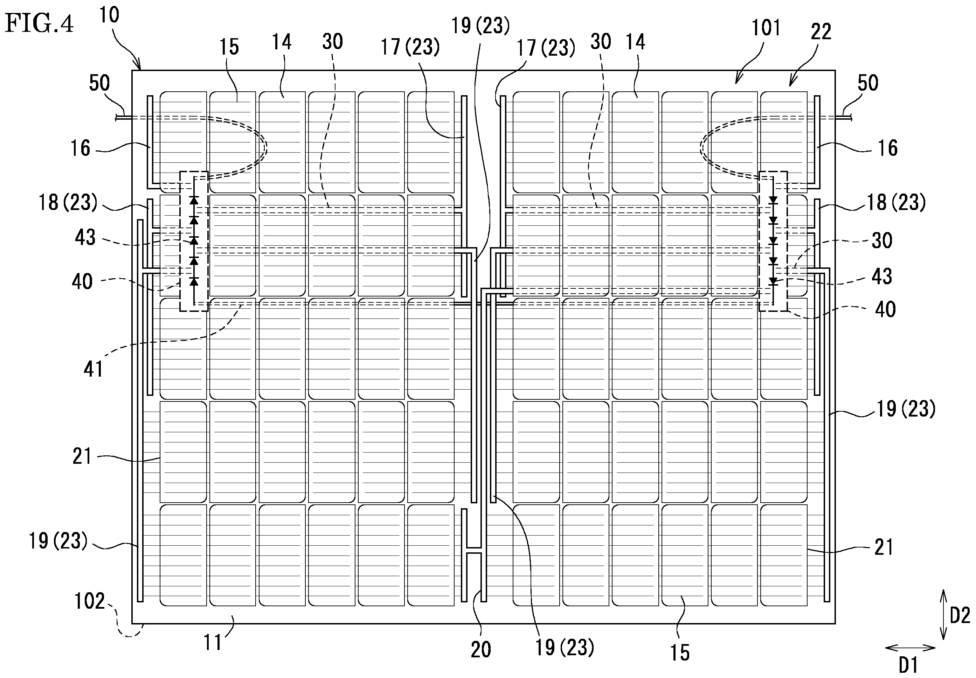

In the present disclosure, the photovoltaic module 10 is not limited to the configuration described in Embodiment 1, but may be configured, for example, as shown in FIG. 4.

FIG. 4 is a schematic plan view of a photovoltaic module 10 according to Embodiment 2 of the present disclosure. In the following description of Embodiments 2 and 3, the basic configuration of the photovoltaic module 10 is common to the one described in Embodiment 1, and common elements are represented by the same reference signs to omit repetitive description.

The photovoltaic string 22 sealed inside the photovoltaic module 10 may include not only the plurality of photovoltaic cell connection units 21 arranged in the second direction D2, but also a plurality of photovoltaic cell connection units 21 arranged in the first direction D1.

In the configuration shown in FIG. 4, the photovoltaic module 10 includes turn-back portions 23 also at a middle part in the first direction D1. At the turn-back portions 23, the starting ends or terminating ends of the photovoltaic cell connection units 21 are connected to the bus bars 17, 18, 19, 20. The bus bars 16, 17, 18, 19 are connected with the output wiring members 30 for extracting output from the photovoltaic cell connection units 21.

For example, the photovoltaic cell connection unit 21 on the upper left in the drawing constitutes a series circuit in which six photovoltaic cells 14 are connected in series with each other. This photovoltaic cell connection unit 21 is connected in series with an adjacent photovoltaic cell connection unit 21 at the middle part in the first direction D1 by the bus bars 17, 19, and is turned back. At an end in the first direction D1 of the adjacent photovoltaic cell connection unit 21 connected via the turn-back portion 23, the photovoltaic cell connection units 21 are connected in series with each other by the bus bar 18 and turned back. In total, ten photovoltaic cell connection units 21, each containing six photovoltaic cells 14, are connected in series with each other to constitute one photovoltaic string 22. In the resulting electric circuit, the photovoltaic module 10 as a whole provides one series circuit in which the photovoltaic cells 14 are connected in series in 6×10 arrangement, with 60 (sixty) serial connections.

The bus bars 19 provided at the turn-back portions 23 have extended first ends, and are longer than the bus bars 17, 18. The first ends of the bus bars 19 are connected with the output wiring members 30 to be routed to the terminal boxes 40 on the back surface 102 side. The photovoltaic cell connection unit 21 on the lower left in the drawing and the photovoltaic cell connection unit 21 on the lower right in the drawing are connected in series with each other by a substantially H-shaped joined bus bar 20. An end of the bus bar 20 is extended to be connected to the terminal box 40 via an output wiring member 30. The output wiring members 30 are arranged between the photovoltaic cell connection units 21 and the back surface protection member, and are led out to the terminal boxes 40.

The terminal boxes 40 are not necessarily provided at the central part on the back surface 102 of the photovoltaic module 10. Instead, the terminal boxes 40 may be provided, one by one, at both ends in the first direction D1 on the back surface 102. Each of the terminal boxes 40 includes four bypass diodes 43, and each of the photovoltaic cell connection units 21 is connected in parallel with corresponding one of the bypass diodes 43. The two terminal boxes 40 are connected with each other by a connection wire 41.

As described above, the photovoltaic module 10 shown in FIG. 4 includes the turn-back portions 23 at the middle part in the first direction D1, and includes ten photovoltaic cell connection units 21 connected in series with each other. This configuration is different from the conventional structure in that the output wiring members 30 are connected to the bus bars 17, 19, 20 also at the turn-back portions 23 at the middle part in the first direction D1, and that each of the photovoltaic cell connection units 21 is connected in parallel with corresponding one of the bypass diodes 43.

Eventually, the photovoltaic module 10 according to the present embodiment works in a manner similar to Embodiment 1. Even when a photovoltaic cell 14 is shaded, the amount of generated power is lost in the single photovoltaic cell connection unit 21 containing the shaded photovoltaic cell 14. This configuration can prevent a hot spot, and can thereby prevent the influence of shading from spreading across the entire photovoltaic string 22 including the other adjacent photovoltaic cell connection units 21. In the photovoltaic module 10 as a whole, deterioration in power generating capacity is confined to one line including the shaded photovoltaic cell 14, and a decrease in the amount of generated power by the photovoltaic module 10 is mitigated in comparison with the conventional structure.

In the photovoltaic module 10, note that the turn-back portions 23 are not necessarily provided at the middle part in the first direction D1. Instead, the turn-back portions 23 may be provided closer to either ends in the first direction D1, in which case the number of serial connections of the photovoltaic cells 14 constituting each photovoltaic cell connection unit 21 may be different between the photovoltaic cells 14 on one end in the first direction D1 and those on the other end in the first direction D1. Also in this modification, each of the photovoltaic cell connection units 21 is connected in parallel with corresponding one of the bypass diodes 43, so that a decrease in the amount of generated power by the photovoltaic module 10 can be mitigated.

### (Embodiment 3)

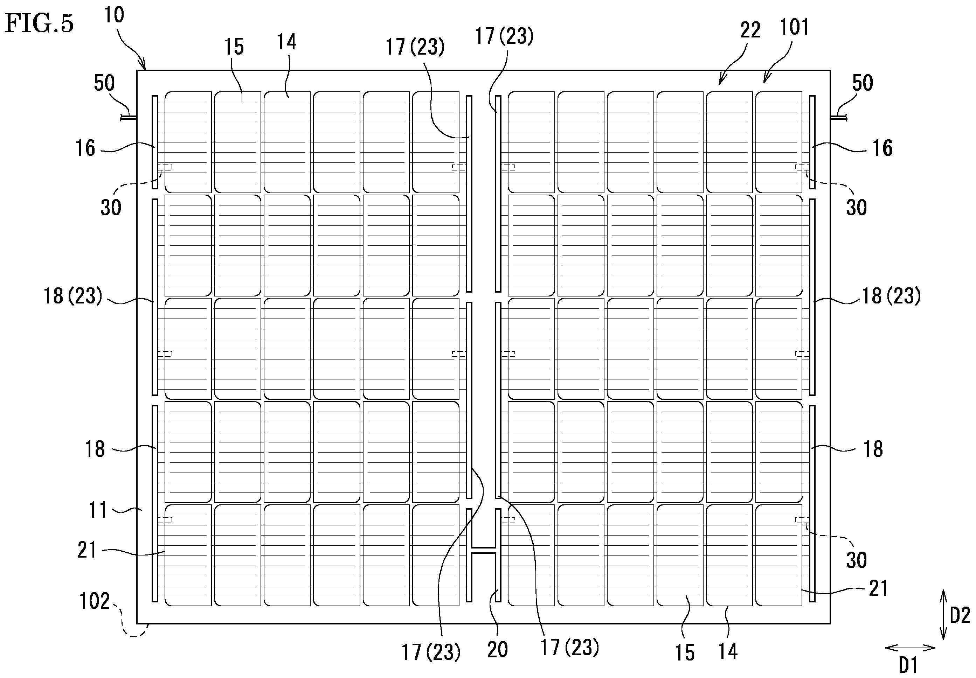

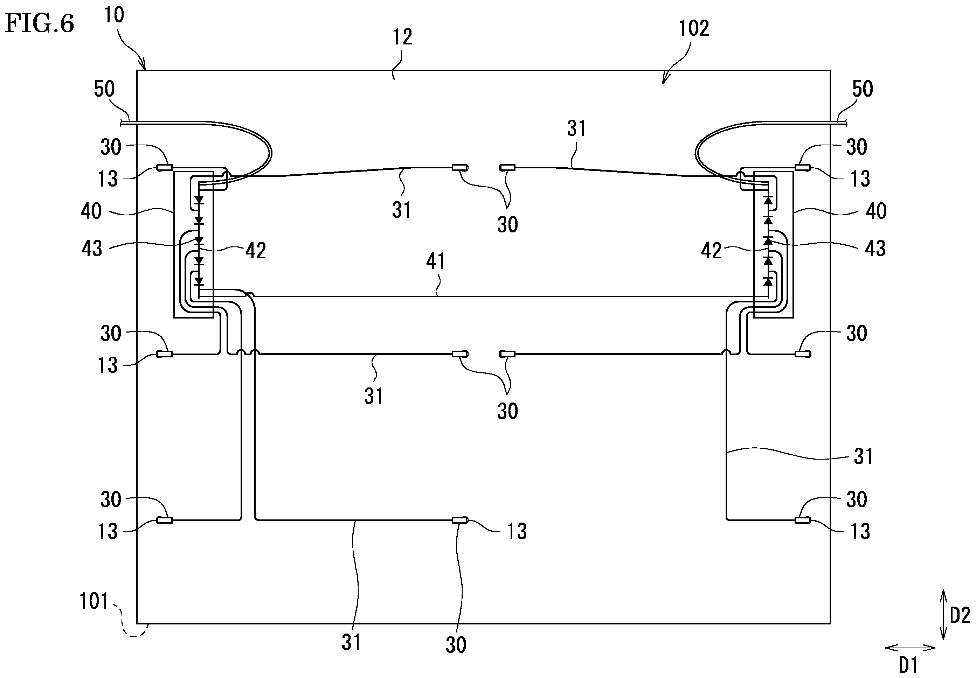

In the present disclosure, the photovoltaic module 10 may be further configured as shown in FIG. 5 and FIG. 6.

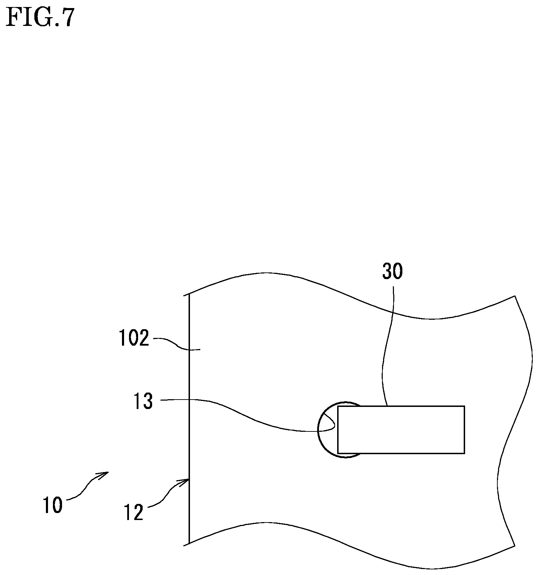

FIG. 5 is a schematic plan view of a photovoltaic module 10 according to Embodiment 3 of the present disclosure. FIG. 6 is a bottom view showing the photovoltaic module 10 of FIG. 5, as seen from the back surface 102 side. FIG. 7 is an enlarged view showing a part of the back surface 102 side of the photovoltaic module 10.

In Embodiments 1 and 2 above, the photovoltaic string 22 is sealed between the transparent substrate 11 and the back surface protection member 12, and arranged between the photovoltaic cell connection units 21 and the back surface protection member (back film) 12, until being led out to the terminal box(es) 40. On the other hand, in the photovoltaic module 10 according to Embodiment 3, the output wiring members 30 are drawn out through the back surface protection member 12 to the back surface 102 side, and connected to the terminal boxes 40 on the back surface 102 side via connection cables 31.

As shown in the photovoltaic module 10 of FIG. 5, a plurality of output wiring members 30 for extracting output is connected to the bus bars 17, 18 at the turn-back portions 23, and drawn out to the back surface 102 side of the photovoltaic module 10. Also in the present embodiment, the photovoltaic module 10 includes not only the turn-back portions 23 at both ends in the first direction D1 but also the turn-back portions 23 at the middle part in the first direction D1. At the turn-back portions 23, the starting ends or terminating ends of the photovoltaic cell connection units 21 are connected to the bus bars 17, 18. The bus bars 16, 17, 18 are further connected with the output wiring members 30 for extracting output from the photovoltaic cell connection units 21.

As shown in FIG. 7, the back surface protection member 12 has outlets 13 penetrating therethrough. Ends of the output wiring members 30 extend outwardly through the outlets 13 to the back surface 102 side of the photovoltaic module 10. As shown in FIG. 5, the output wiring members 30 have first ends thereof connected to the bus bars 16, 17, 18 provided at the starting ends or terminating ends of the photovoltaic cell connection units 21. At their connection points with the bus bars 16, 17, 18 or in the vicinity of their connection points with the bus bars 16, 17, 18, the output wiring members 30 extend outwardly to the back surface 102 side through the outlets 13 that penetrate the back surface protection member 12, as shown in FIG. 7.

The outlets 13 in the back surface protection member 12 are positioned so as not to interfere with the adjacent bus bars 16, 18 and the photovoltaic cells 14. Preferably, the outlets 13 are provided closer to the ends of the bus bars 16, 18 relative to the connection points between the bus bars 16, 18 and the wiring members 15.

In the photovoltaic module 10 as shown in FIG. 6, the output wiring members 30 are provided respectively for the starting ends and terminating ends of the photovoltaic cell connection units 21, and drawn out through the outlets 13 to the back surface 102 side. On the back surface protection member 12, the output wiring members 30 are drawn out from the positions corresponding to the starting ends and terminating ends of the photovoltaic cell connection units 21, and establish electrical continuity with the terminal boxes 40 via the connection cables 31.

When the draw-out position of an output wiring member 30 and the position of a terminal box 40 are apart from each other on the back surface protection member 12, the output wiring member 30 establishes electrical continuity with the terminal box 40 via a connection cable 31. When the position of a terminal box 40 is close to the draw-out position of an output wiring member 30, the output wiring member 30 may establish electrical continuity directly with the terminal box 40 without a connection cable 31. Each terminal box 40 is also connected with an external output cable 50 for extracting output.

In this case, the output wiring members 30 are drawn out to the back surface 102 side of the photovoltaic module 10, and connected to the terminal boxes 40 on the back surface 102 side. This configuration requires neither sealing of the output wiring members 30 inside the photovoltaic module 10 nor coating insulation of the output wiring members 30 for such sealing. Besides, regarding the bus bars 17 that are connected to the photovoltaic cell connection units 21 on each side at the turn-back portions 23 provided in an intermediate part in the first direction D1, the configuration in which the output wiring members 30 are drawn out to the back surface 102 side allows the bus bars 17 on each side to be aligned in a line in the second direction D2, as shown in FIG. 5. This configuration does not cause complicated internal wiring in the photovoltaic module 10 and can facilitate a wiring operation.

According to this wiring configuration, the output wiring members 30 are drawn out to the outside of the back surface protection member 12. This configuration improves the degree of freedom in the position of the terminal boxes 40 and is adaptable to various photovoltaic power systems. Further, as described above and common to Embodiments 1 and 2 above, each of the photovoltaic cell connection units 21 is connected in parallel with corresponding one of the bypass diodes 43. This configuration can minimize the influence of shading over a part of the photovoltaic cells 14, and can mitigate deterioration in power generation efficiency of the photovoltaic module 10.

FIG. 8 is a schematic bottom view showing a main part in another example of an output line connection structure for the photovoltaic module 10 according to Embodiment 3, as seen from the back surface 102 side of the photovoltaic module 10. In FIG. 8, the photovoltaic cells 14, the bus bars 16, 18, and some other components are shown by dashed lines because these components are covered by the back surface protection member 12 and invisible from the back surface 102 side.

The output wiring members 30 may be separate wiring members to be connected with the bus bars 16, 17, 18. Alternatively, as shown in FIG. 8, for example, the output wiring members 30 may be integrated with the bus bars 16, 17, 18. The bus bars 16, 18 are arranged in the second direction D2, and have either of both ends thereof drawn out through the outlets 13 to the back surface 102 side of the photovoltaic module 10.

As shown in FIG. 8, the first ends of the bus bars 16, 18 can serve as output wiring members 30a, by being drawn out through the outlets 13 to the back surface 102 side, with their orientation unchanged and kept in a routing direction that extends in the second direction D2. The output wiring members 30a extending outwardly to the back surface 102 side can be connected to the connection wiring members 31 that are insulated by coating just as in the above embodiment, and can establish electrical continuity with the terminal boxes 40 via the connection wiring members 31. Alternatively, the output wiring members 30a may be connected directly to the terminal boxes 40 without the connection wiring members 31. Although not shown in FIG. 8, the bus bars 16, 18 and the bus bars 17 for the turn-back portions 23 provided in the intermediate part in the first direction D1 can be configured in a similar manner.

According to this configuration, the ends of the bus bars are drawn out to the back surface side and serve as the output wiring members, with their orientation unchanged and kept in the routing direction. This configuration does not require a connection operation between the bus bars and the output wiring members, a processing operation for orienting the extreme ends of the output wiring members inwardly or outwardly in the first direction D1, or other additional operations. As a result, this configuration can simplify operational steps and enhance work efficiency. Besides, this configuration enables wire connections of the output wiring members on the outside of the back surface protection member, thereby avoiding complicated internal wiring and ensuring an easy wiring operation. As a result, this configuration is applicable to various types of photovoltaic power systems.

Also in the photovoltaic module 10 according to Embodiment 3, note that the turn-back portions 23 are not necessarily provided at the middle part in the first direction D1. Instead, the turn-back portions 23 may be provided closer to either ends in the first direction D1, in which case the number of serial connections of the photovoltaic cells 14 constituting each photovoltaic cell connection unit 21 may be different between the photovoltaic cells 14 on one end in the first direction D1 and those on the other end in the first direction D1. The number of series-connected photovoltaic cells 14 that constitute each photovoltaic cell connection unit 21 is not limited to the above-mentioned configuration, and any number of photovoltaic cells 14 may be connected.

In the photovoltaic module 10 according to this embodiment, the photovoltaic cell connection units 21 are disposed in the first direction D1 in two lines, but the number of lines is not limited to two. The photovoltaic module may include the photovoltaic cell connection units 21 in more than two lines, such as three, four, or more. An increase in the number of lines of the photovoltaic cell connection units 21 can also realize an increase the number of turn-back portions 23. Further in this configuration, the output wiring members 30 are connectable to the turn-back portions 23 and also connectable to the bypass diodes 43. Therefore, an increase in the number of turn-back portions 23 can realize an increase the number of bypass diodes 43. Lastly, the terminal box 40 including the bypass diodes 43 may be provided for every line of the photovoltaic cell connection unit 21.

The above-described embodiments are considered in all respects as illustrative and not restrictive. Therefore, the technical scope of the present disclosure should not be construed only by the foregoing embodiments but should be defined by the appended claims. All variations and modifications falling within the equivalency range of the appended claims are intended to be embraced therein.

The present application claims priority under Japanese Patent Application No. 2022-144528, filed on September 12, 2022, the contents of which are incorporated herein by reference in its entirety.

### Reference Signs List

- 10: photovoltaic module
- 101: light-receiving surface
- 102: back surface
- 11: transparent substrate
- 12: back surface protection member
- 13: outlet
- 14: photovoltaic cell
- 15: wiring member
- 16, 17, 18, 19: bus bar
- 21: photovoltaic cell connection unit
- 22: photovoltaic string
- 23: turn-back portion
- 30: output wiring member
- 31: connection cable
- 40: terminal box
- 41: connection wire
- 42: terminal
- 43: bypass diode
- 50: external output cable
- D1: first direction
- D2: second direction

## Claims

1. A photovoltaic module comprising a photovoltaic string and a terminal box, the photovoltaic string comprising a plurality of photovoltaic cells connected in series with each other, wherein
the photovoltaic string comprises a plurality of photovoltaic cell connection units in each of which the plurality of photovoltaic cells adjacent to each other in a first direction is connected in series with each other, and also comprises a turn-back portion at which two of the plurality of photovoltaic cell connection units are connected in series with each other, the two photovoltaic cell connection units being adjacent to each other in a second direction orthogonal to the first direction,
the terminal box comprises a plurality of bypass diodes, and
the turn-back portion is provided with an output wiring member, and each of the plurality of photovoltaic cell connection units is connected in parallel with corresponding one of the bypass diodes.

2. The photovoltaic module according to claim 1, wherein
the turn-back portion comprises a bus bar connected to a starting end or a terminating end of each of the photovoltaic cell connection units, and the output wiring member is connected to the bus bar.

3. The photovoltaic module according to claim 2, wherein
the terminal box comprises a plurality of terminals connected with the plurality of bypass diodes, and
the output wiring member has an end thereof connected to the bus bar and has another end thereof connected, directly or via a connection cable, to corresponding one of the terminals.

4. The photovoltaic module according to any one of claims 1 to 3, wherein
the photovoltaic string comprises the plurality of photovoltaic cell connection units in the first direction.

5. The photovoltaic module according to any one of claims 1 to 4, wherein
the photovoltaic string is sealed between a transparent substrate and a back surface protection member, and
the output wiring member is arranged between the photovoltaic cell connection units and the back surface protection member and is led out to the terminal box.

6. The photovoltaic module according to any one of claims 1 to 4, wherein
the photovoltaic string is sealed between a transparent substrate and a back surface protection member, and
the output wiring member penetrates the back surface protection member, is drawn out to an outside of the back surface protection member, and is connected to the terminal box via a connection cable.
